(19)

Europäisches Patentamt

European Patent Office

Office européen des brevets

(11)     EP 3 646 956 B1

(12)                 **EUROPEAN PATENT SPECIFICATION**

(45) Date of publication and mention
of the grant of the patent:
**27.12.2023   Bulletin 2023/52**

(21) Application number: **18204102.0**

(22) Date of filing: **02.11.2018**

(51) International Patent Classification (IPC):
*G01N 29/34* (2006.01)        *H10N 30/045* (2023.01)
*G01N 29/26* (2006.01)        *G10K 11/34* (2006.01)
*B06B 1/06* (2006.01)

(52) Cooperative Patent Classification (CPC):
**B06B 1/0629; G01N 29/262; G01N 29/34;
G10K 11/346; H10N 30/045**

(54) **A PHASED ARRAY ULTRASOUND APPARATUS, A SYSTEM FOR USER INTERACTION AND A METHOD FOR FORMING A COMBINED ULTRASONIC WAVE BASED ON A PHASED ARRAY ULTRASOUND APPARATUS**

PHASENGESTEUERTE ULTRASCHALLVORRICHTUNG, SYSTEM ZUR BENUTZERINTERAKTION UND VERFAHREN ZUM BILDEN EINER KOMBINIERTEN ULTRASCHALLWELLE BASIEREND AUF EINER PHASENGESTEUERTEN ULTRASCHALLVORRICHTUNG

APPAREIL A ULTRASONS À RÉSEAUX À COMMANDE DE PHASE, SYSTÈME D'INTERACTION UTILISATEUR ET PROCÉDÉ DE FORMATION D'UNE ONDE ULTRASONORE COMBINÉE À BASE D'UN APPAREIL À ULTRASONS À RÉSEAUX A COMMANDE DE PHASE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**06.05.2020   Bulletin 2020/19**

(73) Proprietor: **IMEC VZW
3001 Leuven (BE)**

(72) Inventors:
• **HALBACH, Alexandre
  3001 Leuven (BE)**

• **ROCHUS, Veronique
  3001 Leuven (BE)**
• **BILLEN, Margo
  3001 Leuven (BE)**

(74) Representative: **AWA Sweden AB
Box 5117
200 71 Malmö (SE)**

(56) References cited:
**JP-A- 2016 002 352        US-A- 4 460 841
US-A1- 2015 260 691        US-A1- 2017 205 500**

EP 3 646 956 B1

**Description**

Technical field

The present inventive concept relates to a phased array apparatus for emitting ultrasound. In particular, the present inventive concept relates to emitting ultrasonic waves to be used for haptic feedback so as to use the phased array ultrasound apparatus in a system for user interaction. The present inventive concept also relates to a method for forming an ultrasonic wave using the phased array ultrasound apparatus.

Background

Phased array of ultrasound transducers has received attention as a potential technology to be used for providing tactile sensations without a user being in direct contact with a surface.

By focusing an ultrasonic wave in air, a focus point of sound pressure may be formed in mid-air. This may be used e.g. for providing tactile feedback to a user, such as to allow tactile feedback of interaction with a display without the user forming a direct contact with the display. For instance, the tactile feedback may be provided at a small distance from a display surface or in a plane of a virtual screen. The tactile feedback may give an experience to a user similar to making direct contact with a surface, such as to allow a natural interaction experience to the user.

In Y. Monnai et al, "HaptoMime: Mid-Air Haptic Interaction with a Floating Virtual Screen", UIST '14 Proceedings of the 27th annual ACM symposium on User interface software and technology, pages 663-667, Honolulu, Hawaii, USA, October 5-8, 2014, a mid-air interaction system that allows users to touch a floating virtual screen with hands-free tactile feedback is presented. An ultrasonic phased array transducer delivers focused ultrasound onto the fingertip of the user. The ultrasonic phased array transducer consists of 498 pieces of transducers, the phase and amplitude of each transducer being controlled independently.

US 2017/0205500 discloses an ultrasonic probe, which includes a transmitting unit and a first receiving unit. The transmitting unit includes a transmitting surface, which transmits ultrasonic waves, as well as a second receiving unit. A changing mechanism changes the transmitting unit such that it can receive ultrasonic waves.

US 2015/0260691 discloses a phasing adder which includes delay charge transfer units. The delay charge transfer units obtain signal charge amounts that are not amplified and send and receive the signal charge amounts across a predetermined plurality of stages.

US 4460841 discloses shaded single element piezoelectric transducers and transducer arrays which have a radiation pattern with reduced side lobe levels.

JP 2016002352 discloses an acoustic sensor which comprises an ultrasonic transmitting/receiving element in which a plurality of piezoelectric thin-film parts are arranged in a planar shape, wires that electrically connect the plurality of piezoelectric thin-film parts and input/output electric signals and a switching unit that switches at least a portion of the wires to change electric impedance at the time of transmission and reception of ultrasonic waves.

In order for the individual transducers to cooperate to form a desired focus point of the ultrasonic wave, the transducers are independently controlled.

However, the independent control of a plurality of transducers implies that a large number of connections to the transducers need to be provided. Thus, relatively complex circuitry may be needed, such that the phased array ultrasound apparatus may be expensive. Also, this may be emphasized if the apparatus is to be scaled to provide larger arrays.

Summary

An objective of the present inventive concept is to provide an improved manner of controlling an ultrasonic wave output by a phased array ultrasound apparatus. A particular objective of the present inventive concept is to provide a phased array ultrasound apparatus with simple control circuitry which may still enable accurate control of the emitted ultrasonic wave.

These and other objectives of the present inventive concept are at least partly met by the invention as defined in the independent claims. Preferred embodiments are set out in the dependent claims.

According to a first aspect, there is provided a phased array ultrasound apparatus, the apparatus comprising: an array of ultrasound transducer elements; a plurality of first electrodes and a plurality of second electrodes, wherein each first electrode extends in a first direction in relation to the array of ultrasound transducer elements and each second electrode extends in a second direction, different from the first direction, in relation to the array of ultrasound transducer elements such that each transducer element in the array is associated with one first electrode and one second electrode; wherein each transducer element comprises a layer of piezoelectric material between the first electrode and the second electrode configured to control a vibration of the piezoelectric material to induce emitting of an ultrasonic wave by the transducer element based on a difference between the control signals applied to the first electrode and the second electrode with which the transducer element is associated, wherein control signals applied to a first electrode are shared by the transducer elements along the extension of the first electrode in relation to the array and control signals applied to a second electrode are shared by the transducer elements along the extension of the second electrode in relation to the array, and wherein the phased array ultrasound apparatus is configured to generate, by the shared control signals on the first

electrodes and the second electrodes for each transducer element, a phase delay of the transducer element based on a desired phase delay for each of the transducer elements configured to form a combined ultrasonic wave; characterized in that the piezoelectric material exhibits two polarization states, wherein a phase of an emitted ultrasonic wave by the transducer element differs 180° between the two polarization states of the piezoelectric material; and wherein the phased array ultrasound apparatus is configured to individually change polarization state of the piezoelectric material of selected ultrasound transducer elements, from one of the two polarization states of the piezoelectric material to the other of the two polarization states of the piezoelectric material, before activating at least a subset of the ultrasound transducer elements in the array to form the combined ultrasonic wave, wherein the ultrasound transducer elements for which the polarization state of the piezoelectric material is changed are selected based on a relation between the phase delay of the transducer element to be generated and the desired phase delay of the transducer element for forming the combined ultrasonic wave.

According to the first aspect of the present inventive concept, the control signals applied to the first electrodes and the second electrodes are shared by transducer elements. This implies that each transducer element is not controlled using separate electrode lines and, hence, a number of electrodes associated with the array is substantially reduced. Thus, the wiring required in the apparatus may be reduced, which may imply that a simple circuitry may be used for controlling the phased array ultrasound apparatus.

With an arrangement using electrodes being shared by transducer elements, a control signal applied to an electrode will also be shared by transducer elements. The control signal may not be optimal for providing a desired phase delay by the transducer element in order for the transducer element to provide the desired contribution to the combined ultrasonic wave emitted by the phased array ultrasound apparatus. Thus, the phased array ultrasound apparatus is configured to use piezoelectric material in the ultrasound transducer elements which exhibit two polarization states and the apparatus is further configured to individually change polarization state of the piezoelectric material of selected ultrasound transducer elements. This implies that the phase delay provided by the selected ultrasound transducer elements may be shifted 180° to avoid the selected ultrasound transducer elements destructively interfering with the desired combined ultrasonic wave. Hence, the phased array ultrasound apparatus may be controlled using very few electrodes, while ensuring that the ultrasound transducer elements emit a desired combined ultrasonic wave.

For instance, it may be desired that the phased array ultrasound apparatus is used for focusing an emitted ultrasound wave into a point. The phase delays of ultrasound transducer elements directly beneath the point may then be required to output ultrasonic waves with fairly similar phase delays in order to constructively interfere to create the focus point of ultrasound. A desired phase delay or a phase delay very close to the desired phase delay may be achieved using the shared electrodes. However, ultrasound transducer elements farther away from the focus point may need to have larger phase delays in order to provide a constructive interference at the focus point. Using the shared electrodes, some ultrasound transducer elements may not be controlled to have the desired phase delay. In fact, some ultrasound transducer elements may even be controlled to have an opposite phase to the desired phase delay and may thus destructively interfere with the desired combined ultrasonic wave, which may imply that the ultrasonic wave is not as strong in the focus point as desired. Thus, in order to avoid ultrasound transducer elements to be in complete opposite phase to the desired phase, the ultrasound transducer elements may be shifted 180°. Thanks to the changing of the polarization state, the transducer elements that would otherwise counteract forming of the desired combined ultrasonic wave may be set to contribute to forming of the desired combined ultrasonic wave.

It should be realized that the electrodes may be arranged in many different manners in relation to the array for controlling the array of transducer elements.

For instance, the transducer elements may be arranged in a regular two-dimensional arrangement with the transducer elements extending in rows and columns, wherein the rows are parallel and the columns are parallel and the rows and columns are perpendicular to each other. In such arrangement, the first electrodes may extend along rows such that control signals applied to a first electrode are shared by the transducer elements in the row, whereas the second electrodes may extend along columns such that control signals applied to a second electrode are shared by the transducer elements in the column. This may provide an efficient sharing of the electrodes such that the number of electrodes may be very limited to equal a sum of the number of rows and the number of columns.

However, in alternative arrangements, the first electrodes and the second electrodes may extend diagonally across rows and columns of the array, with first electrodes extending perpendicularly to the second electrodes.

It should further be realized that the first electrodes and the second electrodes need not extend perpendicularly to each other. Rather, the first electrodes and the second electrodes may define an angle different from 90°, e.g. between 45-135°.

The first electrodes and the second electrodes may be arranged such that a transducer element is associated with one of the first electrodes and one of the second electrodes. Thus, the control signals applied to the first electrode associated with the transducer element and the control signals applied to the second electrode associated with the transducer element may control a phase delay of the ultrasonic wave emitted by the transducer element.

Each transducer element may be associated with a unique combination of a first electrode and a second electrode. Thus, each transducer element may be controlled by a unique pair of control signals applied to the first electrode and the second electrode associated with the transducer element.

However, it should be realized that some transducer elements may be configured to be associated with a common combination of a first electrode and a second electrode. This may be achieved e.g. if the electrodes are not arranged to extend along straight lines. This implies that the transducer elements having a common combination of a first electrode and a second electrode will emit ultrasonic waves that are in phase with each other. This may affect the possibility of freely forming the combined ultrasonic wave, but could still work for a phased array ultrasound apparatus having a more limited functionality in output of combined ultrasonic waves. For instance, if the phased array is configured to output combined ultrasonic waves providing a focus point in one or more of a finite number of pre-defined positions, an array having some transducer elements that are associated with a common combination of a first electrode and a second electrode may be useful.

Even though each transducer element may be controlled by a unique combination of a first electrode and a second electrode, the phase delay of each transducer element may not be freely controlled. Since the control signal applied to a first electrode is shared by plural transducer elements and the control signal applied to the second electrode are shared by plural transducer elements, each transducer element may not be controlled to provide an optimal phase delay to provide a desired contribution to the combined ultrasonic wave. Thus, a combination of the control signals applied to the first and the second electrodes may be selected to provide a combined ultrasonic wave which is as close to the desired combined ultrasonic wave as possible. Further, ultrasound transducer elements for which the selected control signals determine a phase delay which counteracts the desired combined ultrasonic wave may have the polarization state changed in order to limit a negative effect of such transducer elements on the desired combined ultrasonic wave.

The entire array of ultrasound transducer elements need not be used in forming the combined ultrasonic wave. For instance, when the ultrasonic wave is to be focused in a focus point, ultrasound transducer elements in the array that are very far away from the focus point need not be active. Thus, the phased array ultrasound apparatus may be configured to activate a subset of the ultrasound transducer elements for forming the combined ultrasonic wave. Also, it should be realized that different parts of the array may be used for forming separate combined ultrasonic waves. For instance, a first subset may be used for forming an ultrasonic wave that is focused in a first focus point, whereas a second, different subset may be used for forming a separate ultrasonic wave that is focused in a second focus point. This may be possible, when the focus points are far apart. However, it should also be realized that all of the transducer elements in the array may be used for forming the combined ultrasonic wave.

As mentioned above, the phased array ultrasound apparatus may be controlled to emit a combined ultrasonic wave which is focused in one or more focus points. This may be particularly useful for providing haptic feedback to a user, e.g. to allow a user interacting with a virtual screen to receive sensation similar to physically touching a screen. Thus, a feedback may be provided when a button is touched. However, the use of the phased array could be used in various other applications, where an accurate control of the ultrasonic wave is desired while providing a simple control circuitry for controlling the phased array of ultrasound transducer elements. For instance, any control of the combined ultrasonic wave may be provided, which does not necessarily imply that the ultrasonic wave is focused in one or more points. Rather, the combined ultrasonic wave may be controlled to provide a desired wavefront of the ultrasonic wave.

The phased array ultrasound apparatus may be configured to emit an ultrasonic wave into air, e.g. as discussed above for providing haptic feedback in relation to a virtual screen. However, the phased array ultrasound apparatus may alternatively be configured to emit an ultrasonic wave into another medium, such as tissue. Naturally, controlling of the phased array ultrasound apparatus may need to take into account propagation properties of the medium into which the ultrasonic wave is emitted.

According to an embodiment, the phased array ultrasound apparatus further comprises a control unit, which is configured to receive information of a desired combined ultrasonic wave to be formed by the phased array ultrasound apparatus, to determine phase delays of the control signals to be applied to the first electrodes and the second electrodes, and to determine a difference between a desired phase delay of each transducer element and a phase delay generated by the control signals.

Thus, the apparatus may comprise a control unit, which may calculate the control signals needed for emitting a desired combined ultrasonic wave.

The control unit may determine an optimal phase delay for each transducer element and may compare the optimal phase delay to an actual phase delay that will be provided by the control signals. Thus, the control unit may identify transducer elements which have a large difference between a desired phase delay and an actual phase delay so as to identify ultrasound transducer elements for which the polarization state is to be changed.

According to an embodiment, the control unit is further configured to determine which transducer elements that are to be activated for forming the desired combined ultrasonic wave for identifying the at least a subset of the ultrasound transducer elements to be activated for forming the combined ultrasonic wave.

Thus, the control unit may identify a subset of ultrasound transducer elements which may need to be activated for forming the desired combined ultrasonic wave. For instance, the control unit may determine that all transducer elements in the array need to be activated or the control unit may determine that one or more discrete subsets of transducer elements in the array need to be activated.

Transducer elements that are not to contribute to emitting the combined ultrasonic wave may be inactive by no control signal being applied on at least one of the first electrode and the second electrode associated with the transducer element. Thus, the at least one electrode may have a floating voltage, which implies that no ultrasonic wave may be emitted by the transducer element.

According to an embodiment, the control unit is further configured to determine phase delays of control signals for the first electrodes and the second electrodes for the at least a subset of the ultrasound transducer elements, wherein the phase delays are determined based on optimizing phase delay of a plurality of ultrasound transducer elements being controlled by the control signals of each of the first electrodes and the second electrodes for the at least a subset of the ultrasound transducer elements.

The control unit may be configured to determine phase delays of control signals in several different ways. For instance, the control unit may first determine a desired phase delay for each of the ultrasound transducer elements that is to contribute to forming the combined ultrasonic wave. Then, the control unit may determine phase delays of the control signals that in combination would provide as small difference as possible from the desired phase delays.

However, such determination may imply that an advanced optimization calculation is performed in order to determine the phase delays. Further, some transducer elements may still be controlled to emit ultrasonic waves with phase delays that are very different from the desired phase delay (even providing an opposite phase, i.e. 180° difference). As the effect of these transducer elements not being correctly controlled may anyway be compensated for by changing the polarization state, a relatively simple algorithm for determining the phase delays of the control signals to be applied to the electrodes may be used.

For instance, the control unit may select one or a few transducer elements for each electrode and may then determine the phase delays to be applied to the electrodes based on selecting the phase delays such that a desired phase delay is provided for the selected transducer elements.

In one embodiment, the phase delays are determined based on ultrasound transducer elements along two perpendicular lines across the subset being set to provide phase delays adapted to forming the combined ultrasonic wave. For instance, transducer elements along a selected row and along a selected column may be used. Then, control signals for the electrode of the selected row and the electrode of the selected column may be set to fit the transducer element which is associated with both the electrode of the selected row and the electrode of the selected column.

In this way, the control signals of the electrodes associated with the selected row and the selected column are defined. The used transducer elements being arranged along the selected row will thus have a defined control signal for the electrode associated with the selected row. Thus, for a used transducer element along the selected row, the control signal on one of the electrodes (the electrode associated with the selected row) has been defined. Then, the control signal to be used on the other electrode of the used transducer element may be determined in order for the transducer element to be controlled with a desired phase delay. In this way, the control signal of an electrode associated with the column in which the used transducer element is arranged will be determined. Based on all the used transducer elements along the selected row, the control signals on each of the electrodes associated with a column may be determined.

In a similar manner, the control signals of the electrodes associated with a row may be determined based on the used transducer elements arranged along the selected column. Hence, the control signals for the electrodes associated with the rows and the columns may be determined based on ensuring that the phase delay of each of the used transducer elements is adapted to forming the combined ultrasonic wave.

It should be realized that instead of using transducer elements along a row and a column of the array, transducer elements along diagonals of the array may be used for determining the control signals to be applied to the electrodes.

According to an embodiment, the control unit is configured, based on determining of the difference between the desired phase delay of each transducer element and the phase delay generated by the control signals, to identify transducer elements for which a difference between 90-270° is determined and to select the identified transducer elements for changing polarization state of the piezoelectric material.

The changing of the polarization state of the piezoelectric material changes the phase of the emitted ultrasonic wave 180°. By selecting to change the polarization state of the piezoelectric material for each transducer element for which a difference of 90-270° between the desired phase delay and generated phase delay is provided, it may be ensured that no transducer element will emit an ultrasonic wave that differs more than 90° between the phase delay of the emitted ultrasonic wave and the desired phase delay.

However, it should be realized that transducer elements may be selected for changing polarization state based on other ranges of the difference between the desired phase delay and the phase delay generated by the control signals. For instance, transducer elements for which a difference between 120-240° is determined may be identified. This implies that a larger difference between the phase delay of the emitted ultrasonic wave and the desired phase delay may be provided. However, fewer transducer elements may need to have the polarization state changed which may imply that a speed of preparing the array for emitting the combined ultrasonic wave may be increased. In yet another embodiment, transducer elements for which a difference between 150-210° is determined may be identified.

According to an embodiment, the piezoelectric material is configured to change polarization state based on a voltage exceeding a threshold voltage being applied between the first electrode and the second electrode, wherein a sign of the applied voltage controls the polarization state of the piezoelectric material.

Hence, the first electrodes and the second electrodes may also be used for changing of polarization state of the piezoelectric material. This implies that no additional circuitry may be needed in order to ensure that the polarization state may be changed.

For instance, the changing of the polarization state may be achieved by providing a DC voltage which exceeds the threshold voltage. The threshold voltage may be larger than a voltage applied by the control signals for generating the ultrasonic wave by the transducer elements such that the control signals will not change the polarization state of the piezoelectric material.

The changing of the polarization state may be individually controlled for each transducer element. Each transducer element may be associated with a unique combination of a first electrode and a second electrode. Thus, by sequentially providing voltages for changing the polarization state on the first electrodes and the second electrodes, a single transducer element at a time may be controlled.

According to an embodiment, the piezoelectric material is polyvinylidene fluoride, PVDF or polyparaxylylene.

The piezoelectric material may be selected such that the piezoelectric material exhibits polarization states, wherein changing of polarization state of the piezoelectric material may be performed in conditions which does not require extensive additional control elements of the apparatus.

PVDF and polyparaxylylene may advantageously be used as the changing of polarization state may e.g. be achieved in room temperature, such that there is no need of e.g. heating the piezoelectric material to enable changing the polarization state.

According to an embodiment, the combined ultrasonic wave comprises a focus point of constructive interference of the ultrasonic waves emitted by each of the transducer elements in the at least sub-set of transducer elements.

Thus, the apparatus may be configured to output a combined ultrasonic wave which defines a focus point by constructive interference of ultrasonic waves emitted by the transducer elements. Transducer elements which would provide destructive interference may have a changed polarization state in order not to counteract forming of the focus point.

The output of a combined ultrasonic wave forming a focus point may be particularly useful in providing haptic feedback to a user.

According to an embodiment, the combined ultrasonic wave comprises a plurality of focus points of constructive interference.

The ultrasound wave to be emitted by a transducer element may be determined in order to enable the ultrasound wave to provide constructive contribution in a plurality of focus points. However, since each transducer element may not be completely individually controlled, the phased array ultrasound apparatus may have limitations in a smallest distance between focus points in the plurality of focus points.

The phased array ultrasound apparatus may be controlled to define a separate subset of transducer elements to be used for each focus point to be provided. Thus, different subsets of the transducer elements could be used for different parts of a combined ultrasonic wave, such that a first focus point may be formed using a first subset, while a second focus point may be formed using a second subset. The array may be divided into several subsets, which may be dynamically defined when needed in dependence on the desired combined ultrasound wave to be formed. The subsets could be controlled simultaneously for forming the plurality of focus points.

According to an embodiment, the phased array ultrasound apparatus further comprises a control signal generating unit, which is configured to generate the control signals for being applied to the first electrodes and the second electrodes.

The control signal generating unit may generate the control signals based on input from the control unit. The control signal generating unit may comprise a plurality of voltage sources which may be connected to a common ground, wherein each voltage source may provide a control signal for one electrode.

The controlling of the voltage sources may be synchronized based on a common clock of the apparatus to ensure that a correct phase delay is provided by the control signals output by the voltage sources.

According to an embodiment, each transducer element comprises a mechanical membrane comprising the layer of piezoelectric material for inducing emitting of an ultrasonic wave by the mechanical membrane.

The mechanical membrane may be controlled to vibrate for forming an ultrasonic wave of the transducer element. This is a suitable manner for providing ultrasonic transducer elements in a large array and enabling simple control of the ultrasonic wave emitted by the transducer elements.

The layer of piezoelectric material may be configured to expand or contract in dependence of a positive or negative electric field being provided between the first electrode and the second electrode associated with the transducer element. Thus, the layer of piezoelectric material may generate a vibration of the mechanical membrane, which may form an ultrasonic wave. The mechanical membrane may comprise one or more further layers attached to the layer of piezoelectric material, such that the vibration of the piezoelectric material may cause a vibration of the entire mechanical membrane for generating the ultrasonic wave.

According to a second aspect, there is provided a system for user interaction, comprising: a user interaction controller for determining a desired haptic feedback to be provided to a user; and the phased array ultrasound apparatus according to any one of the preceding claims, wherein the phased array ultrasound apparatus is arranged to receive input by the user interaction controller for defining the combined ultrasonic wave corresponding to the desired haptic feedback, wherein the phased array ultrasound apparatus is configured to output the combined ultrasonic wave into ambient air for providing the desired haptic feedback in vicinity of phased array ultrasound apparatus.

Effects and features of this second aspect are largely analogous to those described above in connection with the first aspect. Embodiments mentioned in relation to the first aspect are largely compatible with the second aspect.

Thus, a system providing haptic feedback for user interaction may be provided even though the user does not touch a surface. The system may be configured to detect user interaction in any manner. For instance, a position of a finger may be detected through optical or capacitive sensing. The user interaction controller may thus be configured to control the phased array ultrasound apparatus to output a combined ultrasonic wave to provide haptic feedback in the position of the finger such that the system may provide a tactile sensation to the user without the user needing to actually touch a surface. Thus, a user experience of interacting with the system may be similar to interaction with an actual touch surface. For instance, a user pointing at a button may feel a pressure corresponding to actually touching the button.

According to an embodiment, the system further comprises a display for user interaction, wherein the phased array ultrasound apparatus is mounted on or in vicinity of the display for providing haptic feedback above the display in response to user interaction with display.

The user may thus interact with the display by pointing to features presented on the display and may be provided with an experience similar to a touchscreen without having to actually touch the display surface.

This may be beneficial e.g. in reducing wear of a display, as there is no need for a user to actually touch the display surface.

According to a third aspect, there is provided a method for forming a combined ultrasonic wave based on a phased array ultrasound apparatus comprising an array of ultrasound transducer elements, a plurality of first electrodes and a plurality of second electrodes, wherein each first electrode extends in a first direction in relation to the array of ultrasound transducer elements and each second electrode extends in a second direction, different from the first direction, in relation to the array of ultrasound transducer elements such that each transducer element in the array is associated with one first electrode and one second electrode, wherein each ultrasound transducer element in the array comprises a layer of piezoelectric material between the first electrode and the second electrode configured to control a vibration of the piezoelectric material to induce emitting of an ultrasonic wave by the transducer element when activated based on a difference between control signals applied to the first electrode and to the second electrode with which the transducer element is associated, wherein control signals applied to a first electrode are shared by the transducer elements along the extension of the first electrode in the first direction and control signals applied to a second electrode are shared by the transducer elements along the extension of the second electrode in the second direction, wherein the piezoelectric material exhibits two polarization states, wherein a phase of an emitted ultrasonic wave by the transducer element differs 180° between the two polarization states of the piezoelectric material; said method comprising: receiving information of a desired combined ultrasonic wave to be formed by the phased array ultrasound apparatus; determining phase delays of the control signals to be applied to the first electrodes and the second electrodes for forming the desired combined ultrasonic wave; determining a difference between a desired phase delay of each transducer element and a phase delay generated by the determined control signals; based on the determining of the difference, selecting transducer elements for which a polarization state of a piezoelectric material of the transducer element is to be changed; changing the polarization state of the piezoelectric material of the selected ultrasound transducer elements, from one of the two polarization states of the piezoelectric material to the other of the two polarization states of the piezoelectric material; and applying the control signals to the first electrodes and the second electrodes using the determined phase delays to form the desired combined ultrasonic wave.

Effects and features of this third aspect are largely analogous to those described above in connection with the first and second aspects. Embodiments mentioned in relation to the first and second aspects are largely compatible with the third aspect.

The changing of the polarization state of the piezoelectric material of selected ultrasound transducer elements may ensure that the phased array ultrasound apparatus may be controlled to accurately form a desired combined ultrasonic wave while using a simple structure for controlling the transducer elements, such that electrodes are shared by a plurality of transducer elements.

According to an embodiment, the method further comprises determining which transducer elements that are to be activated for forming the desired combined ultrasonic wave for identifying at least a subset of the ultrasound transducer elements to be activated for forming the combined ultrasonic wave and, before changing the polarization state of the piezoelectric material of the selected ultrasound transducer elements, setting a polarization state of the piezoelectric material of each of the transducer elements in the at least a subset to a first polarization state.

Thus, when an ultrasonic wave is to be output, the ultrasound transducer elements which are to contribute to the forming of the desired combined ultrasonic wave may first be determined. For these transducer elements, the polarization state may first be set to a first polarization state to ensure that all the transducer elements are set to the first polarization state. Then, knowing the polarization state of all the transducer elements, the polarization state of the selected transducer elements may be changed so as to avoid that these transducer elements counteract forming of the desired combined ultrasonic wave. In this way, it may be ensured that the polarization state of each transducer element is set as desired, such that the phased array ultrasound apparatus outputs the desired combined ultrasonic wave.

Brief description of the drawings

The above, as well as additional objects, features and advantages of the present inventive concept, will be better understood through the following illustrative and non-limiting detailed description, with reference to the appended drawings. In the drawings like reference numerals will be used for like elements unless stated otherwise.

Fig. 1 is a schematic view of a phased array ultrasound apparatus according to an embodiment.
Fig. 2 is a schematic view of a cross-section of an ultrasound transducer element of the phased array ultrasound apparatus.
Figs 3a-b are schematic views of arrangement of electrodes for controlling an array of ultrasound transducer elements.
Fig. 4 is a chart illustrating optimal phase delays of transducer elements in an array for forming of a desired combined ultrasonic wave.
Fig. 5 is a chart illustrating differences between phase delays generated by control signals applied to row and column electrodes and the optimal phase delays for the transducer elements in the array.
Fig. 6 is a chart illustrating differences between phase delays generated by control signals applied to row and column electrodes and the optimal phase delays for the transducer elements in the array after polarization state of piezoelectric material has been changed for selected transducer elements.
Fig. 7 is a schematic view of a system for user interaction according to an embodiment.
Fig. 8 is a flow chart of a method according to an embodiment.

Detailed description

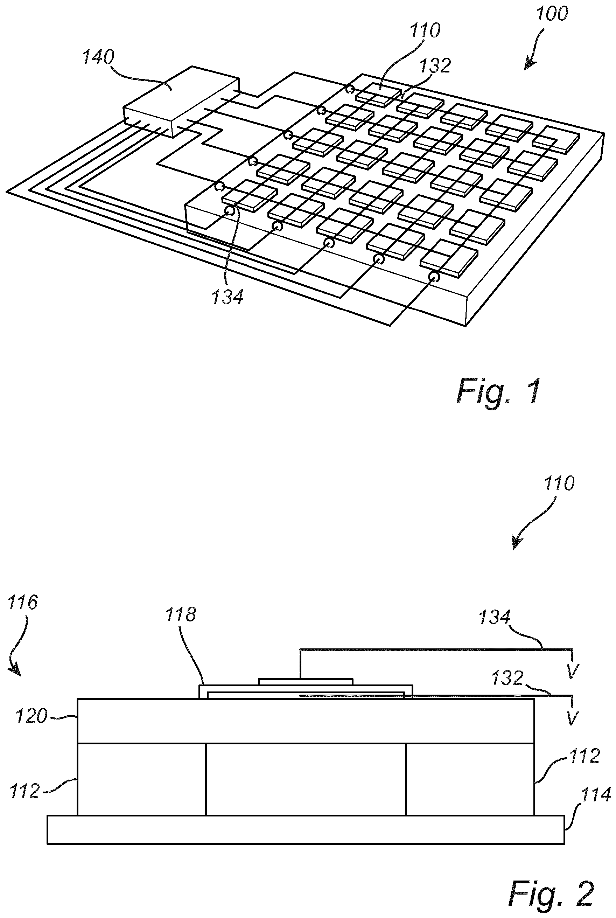

Referring now to Fig. 1, a phased array ultrasound apparatus 100 will be generally described. The phased array ultrasound apparatus 100 comprises an array of ultrasound transducer elements 110. The ultrasound transducer elements 110 in the array may be controlled to emit ultrasonic waves, such that the individual ultrasonic waves from each of the ultrasound transducer elements 110 may interact to form a combined ultrasonic wave. Using the plurality of ultrasound transducer elements 110, a large freedom in designing the combined ultrasonic wave may be provided. For instance, the individual ultrasonic waves may be set to provide constructive interference in a particular point in relation to the array. Thus, the phased array ultrasound apparatus 100 may be used for emitting a combined ultrasonic wave that is focused in a focus point.

The phased array ultrasound apparatus 100 may be used in an application, wherein an accurate control of an emitted ultrasonic wave is desired. The phased array ultrasound apparatus 100 may be used for providing haptic feedback to a user, as the ultrasonic wave may be focused such that the pressure from the ultrasonic wave in the focus point may be sensed by a user. However, it should be realized that the phased array ultrasound apparatus 100 may be used in many different applications, e.g. when an ultrasonic wave is to be used for measurements or imaging, such as by detecting a response of an object being exposed to the ultrasonic wave.

The ultrasound transducer elements 110 in the array are controlled using electrodes 132, 134 for providing control signals that cause the transducer elements 110 to output ultrasonic waves. Each electrode 132, 134 is shared by a plurality of transducer elements 110, such that the electrodes 132, 134 are used for simultaneously controlling plural transducer elements 110. This implies that a limited number of electrodes 132, 134 is needed, such that the control circuitry of the phased array ultrasound apparatus 100 may be relatively simple and require few lines.

The ultrasound transducer elements 110 of the phased array ultrasound apparatus 100 comprises a piezoelectric material exhibiting two polarization states, wherein a phase of an emitted ultrasonic wave by the transducer element differs 180° depending on the two polarization states of the piezoelectric material. The phased array ultrasound apparatus 100 is further configured such that the polarization states of the ultrasound transducer elements 110 may be individually changed.

Since the electrodes 132, 134 are shared by plural transducer elements 110, each transducer element 110 may not be completely individually controlled and, hence, each transducer element 110 may not be set to provide exactly the emitted ultrasonic wave desired in order to perfectly fit the combined ultrasonic wave to be output by the phased array ultrasound apparatus 100. In fact, some ultrasound transducer elements 110 may be caused by the control signals to emit ultrasonic waves that are far from optimal for forming the desired combined ultrasonic wave. For instance, a phase of the emitted ultrasonic wave by a transducer element 110 may be in opposite phase (i.e. 180°) or close to opposite phase compared to the optimal ultrasonic wave to be emitted by the transducer element 110 for perfectly contributing to the desired combined ultrasonic wave. However, by individually changing the polarization state of the ultrasound transducer elements 110 that are in opposite phase or close to opposite phase to optimal, these transducer elements 110 may be set to positively contribute to the desired combined ultrasonic wave.

The phase array ultrasound apparatus 100 may comprise a control unit 140 for determining phase delays of control signals. The phase delays may be set in relation to a common point in time, e.g. based on an ultrasonic wave emitted by a particular ultrasound transducer element 110 (which may thus provide a reference in relation to which the phase delays are determined). The control unit 140 may also be configured to determine which ultrasound transducer elements 110 that will have a difference close to 180° between a desired phase delay and a phase delay generated by the control signals for the transducer element 110. Hence, the control unit 140 may identify the transducer elements 110 for which a change in polarization state of the piezoelectric material is needed.

The control unit 140 may thus control desired control signals to be provided to the electrodes 132, 134 for controlling the ultrasound transducer elements 110 to operate in conjunction so as to form the desired combined ultrasonic wave.

The control unit 140 may be implemented in a general-purpose processing unit (e.g. a central processing unit (CPU)), which may be provided with software for controlling the processing unit to provide the functionality of the control unit 140, as will be described in further detail below. The control unit 140 may alternatively be implemented as firmware arranged e.g. in an embedded system, or as a specifically designed processing unit, such as an Application-Specific Integrated Circuit (ASIC) or a Field-Programmable Gate Array (FPGA), which may be configured to implement functionality of the control unit 140.

Referring now to Fig. 2, an ultrasound transducer element 110 will be described in further detail.

The ultrasound transducer element 110 may be formed by a piezoelectric micromachined ultrasonic transducer (PMUT). The ultrasound transducer elements 110 may be designed so as to allow forming of a plurality of transducer elements 110 in a small area on a common substrate.

The ultrasound transducer element 110 may comprise supporting legs 112 arranged on a substrate 114. Each supporting leg 112 may provide an elevated position in relation to the substrate 114, to which elevated position a mechanical membrane 116 may be attached.

Thus, the mechanical membrane 116 may be suspended between the supporting legs 112. The mechanical membrane 116 together with the supporting legs 112 and the substrate 114 may thus enclose a cavity. The mechanical membrane 116 may be controlled to vibrate above the cavity for forming an ultrasonic wave into a surrounding medium, such as air.

The arrangement of the mechanical membrane 116 in relation to a cavity may be provided in various different ways as would be understood by a person skilled in the art.

The mechanical membrane 116 may comprise a layer 118 of piezoelectric material. The mechanical membrane 116 may comprise several layers attached to each other. The piezoelectric layer 118 may be adapted for causing vibrations of the mechanical membrane 116. The piezoelectric layer 118 may be connected to a second layer 120, which may be fixed to a support. Expansion or contraction of the piezoelectric layer 118 may then cause a deflection of the second layer 120 to form vibrations of the mechanical membrane 116.

The layer 118 of piezoelectric material is sandwiched between a first, bottom electrode 132, which is arranged below the layer 118 of piezoelectric material, and a second, top electrode 134, which is arranged above the layer 118 of piezoelectric material. The electrodes 132, 134 are each electrically connected to receive control signals so that when a voltage is applied between the electrodes 132, 134, the piezoelectric layer 118 will be exposed to an electric field. Piezoelectric properties cause the piezoelectric material to expand or contract in dependence of a positive or negative electric field between the electrodes 132, 134. Thus, an alternating voltage being applied at the electrodes 132, 134 will cause the piezoelectric layer 118 to alternately expand and contract, leading to vibration of the entire mechanical membrane 116. Thus, the vibration may create acoustic pressure waves into the surrounding medium above the mechanical membrane 116.

A frequency of the control signals may thus control a frequency of the emitted acoustic pressure wave. For instance, the ultrasonic transducer element 110 may be controlled to emit an ultrasonic wave having a frequency in a range of 20 kHz - 100 MHz.

The ultrasound transducer element 110 may be formed on a substrate 114, which could for instance be formed by glass. Thus, the apparatus 100 may be formed to be generally transparent, which may facilitate arranging the phased array ultrasound apparatus 100 on a display. Since the transducer elements 110 may be controlled based on merely the electrodes 132, 134, there is no need of providing any circuitry on the substrate 114. However, it should be realized that the substrate 114 may be formed by other materials, such as a semiconductor material or a polymer material. For instance, the substrate 114 may be formed from a thin polymer material, such as polyimide.

The mechanical membrane 116 may comprise a second layer 120, which may be formed from a flexible material. For instance, the second layer 120 may be formed from a polymer material, such as polyimide. The second layer 120 may electrically isolate the piezoelectric layer 118 and ensure that the electrodes 132, 134 may be arranged on a dielectric material.

However, it should be realized that many different options of materials are conceivable as would be understood by a person skilled in the art.

The piezoelectric material may be polyvinylidene fluoride (PVDF) or polyparaxylylene.

The piezoelectric material may be selected such that the piezoelectric material exhibits polarization states, wherein changing of polarization state of the piezoelectric material may be performed with a simple control.

PVDF or polyparaxylylene may advantageously be used as the piezoelectric material, since the changing of polarization state may e.g. be achieved in room temperature. The transducer element 110 may thus be provided with a control signal through the electrodes 132, 134. A relatively high DC voltage may be applied between the electrodes 132, 134 for causing the changing of the polarization state.

In an embodiment, the alternating voltage applied in order to generate the ultrasonic wave may have an amplitude of 10V. The DC voltage applied in order to cause the changing of the polarization state of the piezoelectric material may be larger, e.g. 50V and may be applied for a period of time, such as a few ms. The DC voltage may be set to be sufficiently large in relation to a thickness of the layer 118 of piezoelectric material to ensure that the change of polarization state takes place.

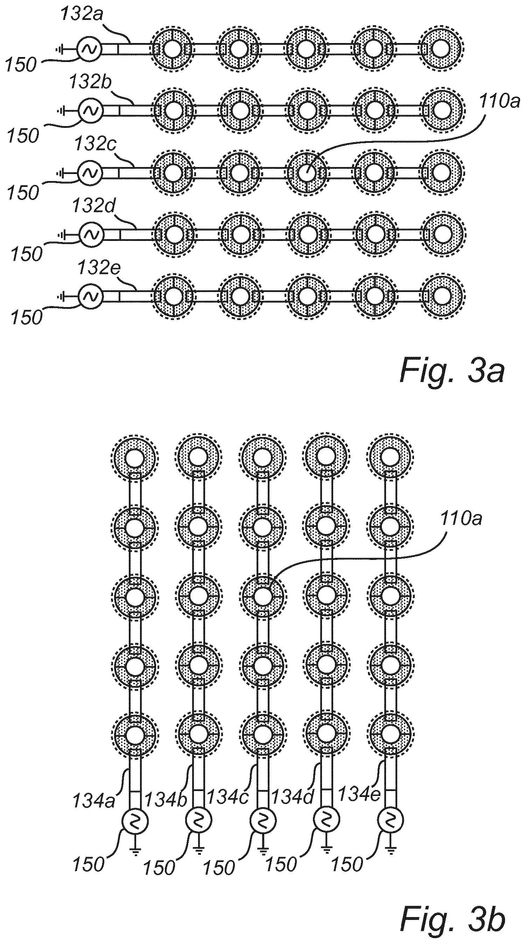

Referring now to Figs 3a-b, an arrangement of electrodes 132, 134 will be described.

As mentioned above, each electrode 132, 134 is shared by a plurality of transducer elements 110. The electrodes 132, 134 are arranged to extend in different manners in relation to the transducer elements 110 of the array.

In Figs 3a-b, electrodes 132, 134 are indicated to extend in parallel to each other. In Fig. 3a, a set of first, bottom electrodes 132a-e are illustrated, whereas in Fig. 3b a set of second, top electrodes 134a-e are illustrated. The first electrodes 132 extend along rows of the array, while the second electrodes 134 extend along columns of the array. It should be understood that the bottom electrodes may instead extend along columns of the array, while the top electrodes extend along rows of the array.

The electrodes 132, 134 may be configured to extend in different relations to the array of transducer elements 110. Also, it should be realized that the transducer elements 110 may be distributed in two dimensions within the array with the array forming a complete unit of the transducer elements 110, but need not necessarily form regular rows and columns. Hence, the electrodes 132, 132 may similarly be arranged to extend in directions that are adapted to an arrangement of the transducer elements 110 in the array.

According to an embodiment, the first electrodes 132 and the second electrodes 134 may extend diagonally across rows and columns of the array. Similar to the arrangement illustrated in Figs 3a-b, the first electrodes 132 may be configured to extend in a perpendicular direction to the second electrodes 134.

However, it should further be realized that the first electrodes and the second electrodes need not extend perpendicularly to each other. Rather, the first electrodes 132 and the second electrodes 134 may define an angle different from 90°, e.g. between 45-135°.

The first electrodes 132 and the second electrodes 134 are arranged such that a transducer element 110 is associated with one of the first electrodes 132 and one of the second electrodes 134. Thus, the control signals applied to the first electrode 132 associated with the transducer element 110 and the control signals applied to the second electrode 134 associated with the transducer element 110 controls a phase delay of the ultrasonic wave emitted by the transducer element 110.

In the embodiment shown in Figs 3a-b, each transducer element 110 is associated with a unique combination of a first electrode 132 and a second electrode 134. Thus, each transducer element 110 is controlled by a unique pair of control signals applied to the first electrode 132 and the second electrode 134 associated with the transducer element 110. When the electrodes 132, 134 are arranged as row electrodes and column electrodes, each transducer element 110 will be controlled by the electrodes corresponding to the row and columns placement of the transducer element 110 in the array. For instance, a centrally placed transducer element 110a, as illustrated in Figs 3a-b will be controlled by control signals on the first electrode 132c and the second electrode 134c.

A control signal is applied to each electrode 132, 134. The piezoelectric material of each transducer element 110 will thus be exposed to a voltage corresponding to a difference in the control signals applied on each of the electrodes 132, 134.

As further illustrated in Figs 3a-b, the phased array ultrasound apparatus 100 may comprise a control signal generating unit, which may comprise a plurality of voltage sources 150. Each voltage source 150 may be connected to a single electrode 132; 134 for applying a control signal to the electrode 132, 134.

The voltage sources 150 may be identical and may be controlled to provide AC voltage signals with identical amplitudes. The frequency of the AC voltage signals will control the frequency of the ultrasonic wave transmitted by the array of ultrasound transducer elements 110. The amplitude of the control signals may be set to trigger actuation of the piezoelectric material of the transducer elements 110 and may, for instance, be 10V.

The voltage sources 150 may receive input to control a phase delay of the control signal. The input to the voltage sources 150 may be synchronized by timing the input to each voltage source 150 from a common control unit 140. Alternatively, the voltage sources 150 may receive an indication of the phase delay to be used and the voltage sources 150 may be connected to a common clock for synchronizing the control signals applied to the electrodes 132, 134 by the voltage sources 150.

As the piezoelectric material of an ultrasound transducer element 110 is exposed to a voltage difference between the electrodes 132, 134, the phase delay of the control signals on the electrodes 132, 134 will be selected so that the difference in phase delays of the two control signals on the bottom and top electrodes 132, 134 associated with the ultrasound transducer element 110 will control the ultrasound transducer element 110 to emit an ultrasonic wave with a desired phase delay.

The array of ultrasound transducer elements 110 may be controlled such that all transducer elements 110 may contribute to forming the combined ultrasonic wave. However, as an alternative, only a subset of the transducer elements 110 may be used in forming the combined ultrasonic wave.

The electrodes 132, 134 which are associated with at least one transducer element 110 in the subset will be controlled with a control signal having a desired phase delay. Electrodes which are not associated with any transducer element 110 in the subset may be set to a floating voltage. For instance, a row of transducer elements 110 may not be part of the subset for forming the combined ultrasonic wave and the row electrode may thus be set to floating voltage. This implies that no ultrasound will be emitted by the transducer elements 110 in the row.

It should also be realized that a plurality of subsets within the array of transducer elements 110 may be separately controlled simultaneously. Thus, the array of transducer elements 110 may be used for simultaneously forming several combined ultrasonic waves, such as for focusing ultrasound in a plurality of focus points at the same time.

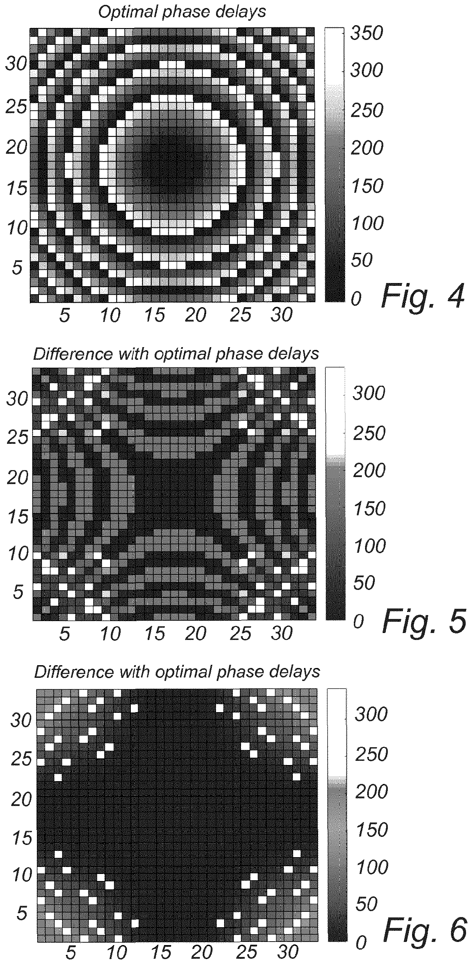

Referring now to Figs 4-6, control of the array of ultrasound transducer elements 110 will be further described in relation to forming a combined ultrasonic wave which is focused in a focus point.

In Fig. 4, an optimal phase delay of each ultrasound transducer element in an array is illustrated for forming a combined ultrasonic wave with a focus point 1 cm above a center of the array, wherein an array size is 2 cm x 2 cm and a diameter of a transducer element 110 is 500 $\mu$m.

As can be seen in Fig. 4, the optimal phase delay is quite similar close to the center of the array, but varies substantially farther away from the center of the array.

The control unit 140 may determine the control signals to be used for the first electrodes 132 and the second electrodes 134 based on the optimal phase delays. In an embodiment, the phase delays to be used for the control signals may be set based on one transducer element 110 for each electrode 132, 134. Thus, a few transducer elements 110 may be selected to be used for determining the control signals to be applied to the electrodes 132, 134. For instance, the transducer elements 110 in the central row and the central column of the array may be selected.

The determining of the control signals may then start by the central row and the central column may be set as reference to then enable determining the control signals to be applied to the remaining electrodes. The phase delay of the central row may thus be set to 0°, whereas the phase on the central column may be set to 180° (as the transducer elements will experience a difference between the voltages of the control signals). Further, the phase delays of the row electrodes 132 may be set to 2*(optimal phase) for the transducer element 110 on the central column for the row. Then, the phase delays of the column electrodes 134 may be set to 2*(optimal phase) + 180° for the transducer element 110 on the central row for the column. For example, a transducer element on the central row with an optimal phase delay of 32° will be exposed to a voltage (for a 500 kHz frequency), as given by trigonometric relations of:

$$\sin(2\pi*500000*t+0°) - \sin(2\pi*500000*t+244°)=1.696*\sin(2\pi*500000*t+32°).$$

It should be realized that the control signals may be determined in other ways. For instance, transducer elements 110 along diagonals in the array may alternatively be selected to be used for determining the phase delays of each of the control signals.

According to another alternative, the control unit 140 may be configured to determine a combination of phase delays of the control signals which would provide as small combined difference as possible from the desired phase delays. Thus, the control signals may be determined in an optimization calculation taking the desired phase delay of each transducer element 110 in the subset of the array to be activated into account.

Once the control signals for the first and second electrodes 132, 134 have been determined, a difference between the phase delay of the emitted ultrasonic wave compared to the optimal phase delay is determined for each transducer element 110. Since the control signals are shared by several transducer elements 110, the phase delays will not be optimal for each transducer element 110.

In Fig. 5, a difference between the phase delay of the emitted ultrasonic wave if the determined control signals would be used and the optimal phase delay is illustrated for the array of transducer elements 110. For the illustration in Fig. 5, the control signals have been determined using the transducer elements 110 in the central row and the central column.

As may be seen in Fig. 5, for some transducer elements 110, there is a difference of approximately 180° to the optimal phase delay. This implies that such transducer elements 110 will emit ultrasonic waves that will counteract forming of the desired combined ultrasonic wave.

The control unit 140 may be configured to determine transducer elements 110 having a large error of the provided control signals in relation to the optimal phase delay. Thus, these ultrasound transducer elements 110 are selected for re-polarization, such that the polarization state of the piezoelectric material of the selected ultrasound transducer elements 110 is changed. Changing the polarization state will switch action of contraction and expansion of the piezoelectric material such that the phase of the emitted ultrasonic wave will be shifted by 180° for the transducer element 110. Hence, by means of the changing of the polarization state, the transducer elements 110 may be set to emit an ultrasonic wave which is close to the optimal ultrasonic wave of the individual transducer element 110 for forming the desired combined ultrasonic wave.

The control unit 140 is thus configured to identify the transducer elements 110 for which the polarization state of the piezoelectric material should be changed. The control unit 140 may determine which transducer elements 110 that have a particular difference between the generated phase delay based on the control signals and the optimal phase delay. For instance, the control unit 140 may identify transducer elements 110 for which the difference is within 90-270°.

The control unit 140 may further trigger changing of the polarization state for the identified transducer elements 110. Then, the voltage sources 150 associated with a transducer element 110 for which the polarization state is to be changed may be controlled for exposing the piezoelectric material to a DC voltage for changing the polarization state. The transducer elements 110 for which the polarization state of the piezoelectric material is to be changed may be addressed sequentially using the pair of electrodes 132, 134 associated with the respective transducer element 110.

Changing of the polarization state implies that the phase delay of an ultrasonic wave emitted by the transducer element 110 will be shifted 180°. This implies that, for the identified transducer elements 110, the difference between the generated phase delay based on the control signals and the optimal phase delay will be reduced.

Changing polarization state for transducer elements 110 having a difference in a range of 90-270° implies that a maximum difference between the generated phase delay based on the control signals and the optimal phase delay will be 90°.

However, it should be realized that another range of differences may be used for selecting transducer elements 110 for which the polarization state of the piezoelectric material is to be changed. The changing of polarization state may affect a time delay of output of a combined ultrasonic wave by the phased array ultrasound apparatus 100. Thus, it may be desired that the polarization state of the piezoelectric material is changed for only a few transducer elements 110. Further, for transducer elements 110 having a difference close to 90° between the generated phase delay based on the control signals and the optimal phase delay, the difference will be close to 270° after changing of the polarization state. Thus, the contribution of such a transducer element 110 to the forming of the combined ultrasonic wave will only be marginally improved. Therefore, the changing of the polarization state may be performed only for transducer elements 110 for which a large improvement in contribution to forming of the combined ultrasonic wave may be provided. Hence, according to an embodiment, transducer elements 110 for which a difference between 120-240° is determined may be identified and selected for changing the polarization state. In another embodiment, transducer elements for which a difference between 150-210° is determined may be identified and selected for changing the polarization state.

Referring now to Fig. 6, a difference between the phase delay of the emitted ultrasonic wave if the determined control signals would be used and the optimal phase delay is illustrated for the array of transducer elements 110, after the polarization state has been changed for all transducer elements 110 for which the difference was in the range of 90-270°. However, in selecting the transducer elements 110 for changing polarization, some elements at corners of the array were not considered, which is why there remain some elements in Fig. 6 with a difference in the range of 90-270°. Thus, the controlling of the array of transducer elements 110 illustrated in Fig. 6 may be even further improved.

As illustrated in Fig. 6, the difference is very small for transducer elements 110 in a center of the array. Thus, the array of ultrasound transducer elements 110 will be controlled to form a combined ultrasonic wave which fits very well to the desired ultrasonic wave.

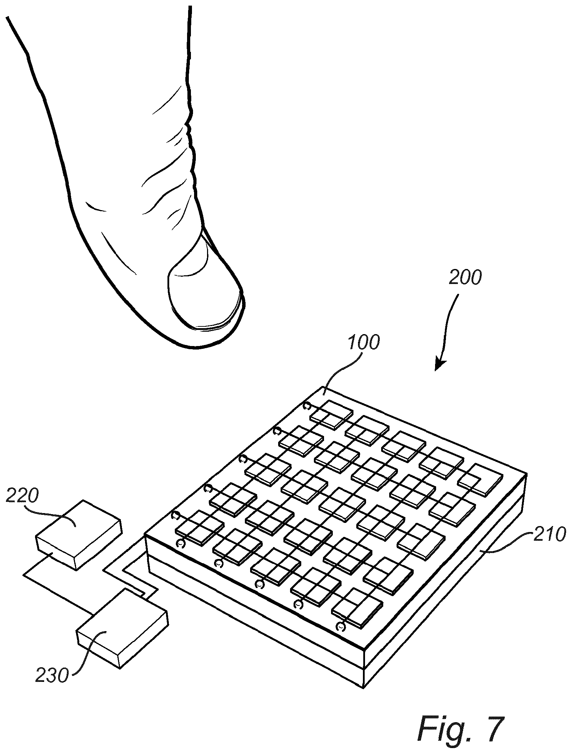

Referring now to Fig. 7, a system 200 for user interaction will be described.

The system 200 may comprise the phased array ultrasound apparatus 100 as described above. The phased array ultrasound apparatus 100 may be arranged within the system 200 so as to output a combined ultrasonic wave for providing haptic feedback to a user of the system 200.

The system 200 may comprise a display 210 with which the user may interact. The display 210 may be used for presenting information to the user. The display 210 may for instance display objects with which the user may interact for providing input to the system 200. The user may thus point at an object on the display 210 in order to select the object and control the system 200 to perform an action based on the selected object. For instance, a button may be presented as an object and the user may push the button in order to trigger a functionality of the system 200.

The system 200 may comprise a sensor 220 for detecting user interaction. For instance, the sensor 220 may be configured to detect user interaction by detecting a reflected light wave for e.g. determining a position of a finger in relation to the display. According to an alternative, the sensor 220 may sense a capacitance due to presence of a finger. The sensor 220 may be configured to detect user interaction without requiring the user to touch the display 210. It should be realized that a person skilled in the art may implement the sensor 220 based on some other technology.

The input from the sensor 220 may be provided to a user interaction controller 230. The user interaction controller 230 may be configured to determine a feedback to be provided to the user in response to a detected user input. Thus, the user interaction controller 230 may be configured to control output of an ultrasonic wave so as to provide haptic feedback in the position of the finger of the user such that the user will experience a pressure at the finger so as to mimic touching an actual surface.

The user interaction controller 230 may thus determine a desired combined ultrasonic wave to be formed by the phased array ultrasound apparatus 100 as feedback to the input by the user. The user interaction controller 230 may provide input to the control unit 140 such that the control unit 140 may control the array of ultrasound transducer elements 110 to form the desired combined ultrasonic wave, as described in detail above.

The user interaction controller 230 may be implemented in a general-purpose processing unit (e.g. a CPU), which may be provided with software for controlling the processing unit to provide the functionality of the control unit 230. The user interaction controller 230 may alternatively be implemented as firmware arranged e.g. in an embedded system, or as a specifically designed processing unit, such as an Application-Specific Integrated Circuit (ASIC) or a Field-Programmable Gate Array (FPGA), which may be configured to implement functionality of the user interaction controller 230.

The user interaction controller 230 and the control unit 140 may be implemented in separate software, which may be executed by a common processing unit. However, the user interaction controller 230 and the control unit 140 may alternatively be configured to be implemented in separate processing units.

The system 200 may be configured to provide haptic feedback at a distance above a display 210. This implies that the user need not physically touch a display surface, which may reduce wear on the display 210.

The array of ultrasound transducer elements 110 may be integrated in a common housing with the display 210. The array of ultrasound transducer elements 110 may be mounted above pixel elements for forming an image on the display 210. At least major components of the phased array ultrasound apparatus 100 may be transparent (e.g. a glass substrate), so that the arrangement of the phased array ultrasound apparatus 100 on the display 210 would not affect presentation of information to a user on the display 210. The array of ultrasound transducer elements 110 may thus output the combined ultrasonic wave from a surface of the display 210, which implies that the desired combined ultrasonic wave may be easily determined.

The phased array ultrasound apparatus 100 may be used to output a combined ultrasonic wave having plural focus points or to simultaneously output plural combined ultrasonic waves using different subsets of the array. Thus, the system 200 may provide feedback in several points at the same time so as to allow for haptic feedback in multi-touch interaction.

It should be realized that the system 200 may be configured in other manners for providing user interaction. For instance, the array of ultrasound transducer elements 110 may be arranged below the display 210. Thus, the ultrasound will need to be transmitted through the display 210 and an effect of the display 210 on propagation of the ultrasonic wave need to be taken into account.

According to an alternative, the system 200 may be configured to present an image to a user in a virtual display surface, which may be touched by the user. The user may further receive haptic feedback in the virtual display surface through the combined ultrasonic wave output by the phased array ultrasound apparatus 100.

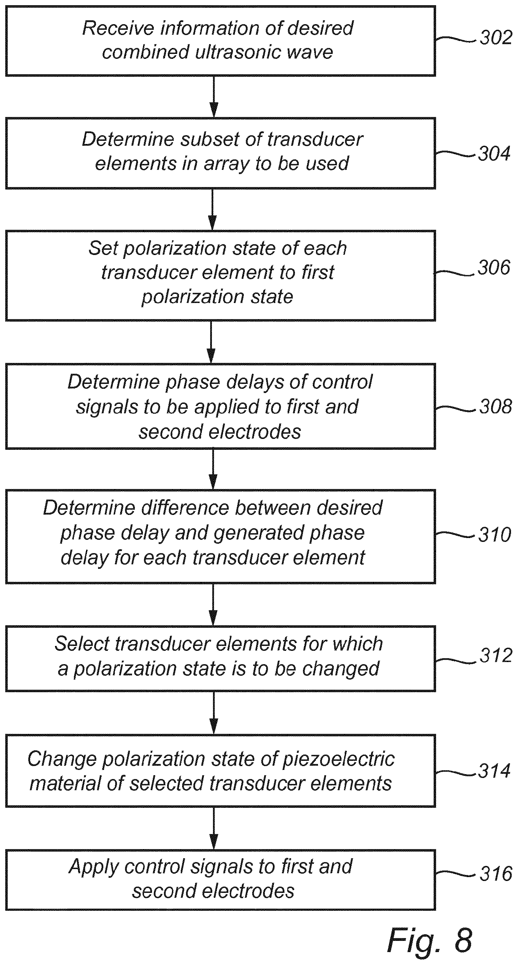

Referring now to Fig. 8, a method for forming a combined ultrasonic wave using the phased array ultrasound apparatus 100 will be described.

The method comprises receiving 302 information of a desired combined ultrasonic wave to be formed by the phased array ultrasound apparatus. The information may be based on a desire to output an ultrasonic wave with a focus point so as to provide haptic feedback to a user pointing a fingertip at the focus point.

The method may comprise determining 304 a subset of the array of ultrasound transducer elements 110 which subset is to contribute to forming of the combined ultrasonic wave. Thus, only the transducer elements 110 in the subset need to be controlled.

The method may further comprise setting 306 a polarization state of the piezoelectric material of each transducer element 110 within the subset to a first polarization state. This may be performed by providing control signals on the first electrodes 132 and the second electrodes 134 associated with the transducer elements 110 in the subset, such that the piezoelectric material of each transducer element 110 is exposed to a DC voltage of +50V.

The method further comprises determining 308 phase delays of the control signals to be applied to the first electrodes 132 and the second electrodes 134 for forming the desired combined ultrasonic wave. These phase delays may be determined as described above by determining the phase delays to be provided to selected transducer elements 110 (e.g. along two perpendicular lines in the array) for determining the control signals.

The method further comprises determining 310 a difference between a desired phase delay of each transducer element 110 and a phase delay generated by the determined control signals. Then, the method further comprises, based on the determining of the difference, selecting 312 transducer elements 110 for which a polarization state of a piezoelectric material of the transducer element 110 is to be changed. Thus, for instance, each transducer element 110 for which the difference of the phase delays is within the range of 180-270° may be selected.

The method may further comprise changing 314 the polarization state of the piezoelectric material of the selected ultrasound transducer elements 110. This may be performed by sequentially providing control signals on the first electrodes 132 and the second electrodes 134 associated with each of the selected transducer elements 110, such that the piezoelectric material of each selected transducer element 110 is exposed to a DC voltage of -50V for changing the polarization state of the piezoelectric material to the second polarization state.

The method may further comprise applying 316 the control signals to the first electrodes 132 and the second electrodes 134 using the determined phase delays such that the array of transducer elements 110 will form the combined ultrasonic wave.

In the above the inventive concept has mainly been described with reference to a limited number of examples. However, as is readily appreciated by a person skilled in the art, other examples than the ones disclosed above are equally possible within the scope of the inventive concept, as defined by the appended claims.

For instance, the method need not necessarily set the polarization state of each transducer element 110 to a first polarization state. Rather, information of the polarization state of each transducer element 110 may be stored in a memory, such that the control unit 140 may, after determining the differences between the desired phase delays and the phase delay that will be generated based on the determined control signals, determine which polarization state that is to be used for each transducer element 110. These determined polarization states may be compared to the stored information of polarization state to identify transducer elements 110 for which a polarization state need to be changed and, then, the polarization state may be changed for those identified transducer elements 110.

**Claims**

1. A phased array ultrasound apparatus, the apparatus (100) comprising:

   an array of ultrasound transducer elements (110);
   a plurality of first electrodes (132) and a plurality of second electrodes (134), wherein each first electrode (132) extends in a first direction in relation to the array of ultrasound transducer elements (110) and each second electrode (134) extends in a second direction, different from the first direction, in relation to the array of ultrasound transducer elements (110) such that each transducer element (110) in the array is associated with one first electrode (132) and one second electrode (134);
   wherein each transducer element (110) comprises a layer (118) of piezoelectric material between the first electrode (132) and the second electrode (134) configured to control a vibration of the piezoelectric material to induce emitting of an ultrasonic wave by the transducer element (110) based on a difference between the control signals applied to the first electrode (132) and the second electrode (134) with which the transducer element is associated, wherein control signals applied to a first electrode (132) are shared by the transducer elements (110) along the extension of the first electrode (132) in relation to the array and control signals applied to a second electrode (134) are shared by the transducer elements (110) along the extension of the second electrode (134) in relation to the array, and wherein the phased array ultrasound apparatus is configured to generate, by the shared control signals on the first electrodes and the second electrodes for each transducer element, a phase delay of the transducer element based on a desired phase delay for each of the transducer elements configured to form a combined ultrasonic wave;

**characterized in that:**

the piezoelectric material exhibits two polarization states, wherein a phase of an emitted ultrasonic wave by the transducer element (110) differs 180° between the two polarization states of the piezoelectric material; and wherein the phased array ultrasound apparatus (100) is configured to individually change polarization state of the piezoelectric material of selected ultrasound transducer elements (110), from one of the two polarization states of the piezoelectric material to the other of the two polarization states of the piezoelectric material, before activating at least a subset of the ultrasound transducer elements (110) in the array to form the combined ultrasonic wave, wherein the ultrasound transducer elements (110) for which the polarization state of the piezoelectric material is changed are selected based on a relation between the phase delay of the transducer element (110) to be generated and the desired phase delay of the transducer element (110) for forming the combined ultrasonic wave.

2. The phased array ultrasound apparatus according to claim 1, further comprising a control unit (140), which is configured to receive information of a desired combined ultrasonic wave to be formed by the phased array ultrasound apparatus (100), to determine phase delays of the control signals to be applied to the first electrodes (132) and the second electrodes (134), and to determine a difference between a desired phase delay of each transducer element (110) and a phase delay generated by the control signals.

3. The phased array ultrasound apparatus according to claim 2, wherein the control unit (140) is further configured to determine which transducer elements (110) that are to be activated for forming the desired combined ultrasonic wave .

4. The phased array ultrasound apparatus according to claim 2 or 3, wherein the control unit (140) is further configured to determine phase delays of control signals for the first electrodes (132) and the second electrodes (134) for the at least a subset of the ultrasound transducer elements (110), wherein the phase delays are determined based on optimizing phase delay of a plurality of ultrasound transducer elements (110) being controlled by the control signals of each of the first electrodes (132) and the second electrodes (134) for the at least a subset of the ultrasound transducer elements (110).

5. The phased array ultrasound apparatus according to any one of claims 2-4, wherein the control unit (140) is configured, based on determining of the difference between the desired phase delay of each transducer element (110) and the phase delay generated by the control signals, to identify transducer elements (110) for which a difference between 90-270° is determined and to select the identified transducer elements (110) for changing polarization state of the piezoelectric material.

6. The phased array ultrasound apparatus according to any one of the preceding claims, wherein the piezoelectric material is configured to change polarization state based on a voltage exceeding a threshold voltage being applied between the first electrode (132) and the second electrode (134), wherein a sign of the applied voltage controls the polarization state of the piezoelectric material.

7. The phased array ultrasound apparatus according to any one of the preceding claims, wherein the piezoelectric material is polyvinylidene fluoride, PVDF or polyparaxylylene.

8. The phased array ultrasound apparatus according to any one of the preceding claims, wherein the combined ultrasonic wave comprises a focus point of constructive interference of the ultrasonic waves emitted by each of the transducer elements (110) in the at least a subset of the ultrasound transducer elements (110).

9. The phased array ultrasound apparatus according to claim 8, wherein the combined ultrasonic wave comprises a plurality of focus points of constructive interference.

10. The phased array ultrasound apparatus according to any one of the preceding claims, further comprising a control signal generating unit (150), which is configured to generate the control signals to be applied to the first electrodes (132) and the second electrodes (134).

11. The phased array ultrasound apparatus according to any one of the preceding claims, wherein each transducer element (110) comprises a mechanical membrane (116) comprising the layer (118) of piezoelectric material, the layer (118) of piezoelectric material being configured to induce emitting of an ultrasonic wave by the mechanical membrane (116).

**12.** A system for user interaction, comprising:

a user interaction controller (230) for determining a desired haptic feedback to be provided to a user; and the phased array ultrasound apparatus (100) according to any one of the preceding claims, wherein the phased array ultrasound apparatus (100) is arranged to receive input by the user interaction controller (230) for defining the combined ultrasonic wave corresponding to the desired haptic feedback, wherein the phased array ultrasound apparatus (100) is configured to output the combined ultrasonic wave into ambient air for providing the desired haptic feedback in vicinity of phased array ultrasound apparatus (100).

**13.** The system according to claim 12, further comprising a display (210) for user interaction, wherein the phased array ultrasound apparatus (100) is mounted on or in vicinity of the display for providing haptic feedback above the display (210) in response to user interaction with display (210).

**14.** A method for forming a combined ultrasonic wave based on a phased array ultrasound apparatus (100) comprising an array of ultrasound transducer elements (110), a plurality of first electrodes (132) and a plurality of second electrodes (134), wherein each first electrode (132) extends in a first direction in relation to the array of ultrasound transducer elements (110) and each second electrode (134) extends in a second direction, different from the first direction, in relation to the array of ultrasound transducer elements (110) such that each transducer element (110) in the array is associated with one first electrode (132) and one second electrode (134), wherein each ultrasound transducer element (110) in the array comprises a layer (118) of piezoelectric material between the first electrode (132) and the second electrode (134) configured to control a vibration of the piezoelectric material to induce emitting of an ultrasonic wave by the transducer element when activated based on a difference between control signals applied to the first electrode (132) and to the second electrode (134) with which the transducer element is associated, wherein control signals applied to a first electrode (132) are shared by the transducer elements (110) along the extension of the first electrode (132) in the first direction and control signals applied to a second electrode (134) are shared by the transducer elements (110) along the extension of the second electrode (134) in the second direction,

wherein the piezoelectric material exhibits two polarization states, wherein a phase of an emitted ultrasonic wave by the transducer element (110) differs 180° between the two polarization states of the piezoelectric material;
said method comprising:

receiving (302) information of a desired combined ultrasonic wave to be formed by the phased array ultrasound apparatus (100);
determining (308) phase delays of the control signals to be applied to the first electrodes (132) and the second electrodes (134) for forming the desired combined ultrasonic wave;
determining (310) a difference between a desired phase delay of each transducer element (110) and a phase delay generated by the determined control signals;
based on the determining of the difference, selecting (312) transducer elements (110) for which a polarization state of a piezoelectric material of the transducer element (110) is to be changed;
changing (314) the polarization state of the piezoelectric material of the selected ultrasound transducer elements (110), from one of the two polarization states of the piezoelectric material to the other of the two polarization states of the piezoelectric material; and
applying (316) the control signals to the first electrodes (132) and the second electrodes (134) using the determined phase delays to form the desired combined ultrasonic wave.

**15.** The method according to claim 14, further comprising determining (304) which transducer elements (110) that are to be activated for forming the desired combined ultrasonic wave and, before changing the polarization state of the piezoelectric material of the selected ultrasound transducer elements (110), setting (306) a polarization state of the piezoelectric material of each of the transducer elements (110) in the at least a subset to a first polarization state.


**Patentansprüche**

**1.** Phasengesteuerte Ultraschallvorrichtung, wobei die Vorrichtung (100) umfasst:

eine Anordnung von Ultraschallwandlerelementen (110);
eine Vielzahl von ersten Elektroden (132) und eine Vielzahl von zweiten Elektroden (134), wobei sich jede erste Elektrode (132) in einer ersten Richtung in Bezug auf die Anordnung von Ultraschallwandlerelementen (110) erstreckt und sich jede zweite Elektrode (134) in einer zweiten Richtung, die anders als die erste Richtung ist, in Bezug auf die Anordnung von Ultraschallwandlerelementen (110) erstreckt, so dass jedes Wandlerelement (110) in der Anordnung einer einzigen ersten Elektrode (132) und einer einzigen zweiten Elektrode (134) zugeordnet ist;

wobei jedes Wandlerelement (110) eine Schicht (118) von piezoelektrischem Material zwischen der ersten Elektrode (132) und der zweiten Elektrode (134) umfasst, die dazu konfiguriert ist, eine Vibration des piezoelektrischen Materials zu steuern, um eine Emission einer Ultraschallwelle durch das Wandlerelement (110) basierend auf einer Differenz zwischen den Steuersignalen, die an die erste Elektrode (132) und die zweite Elektrode (134) angelegt werden, denen das Wandlerelement zugeordnet ist, zu induzieren, wobei Steuersignale, die an eine erste Elektrode (132) angelegt werden, von den Wandlerelementen (110) entlang der Erstreckung der ersten Elektrode (132) in Bezug auf die Anordnung gemeinsam genutzt werden, und Steuersignale, die an eine zweite Elektrode (134) angelegt werden, von den Wandlerelementen (110) entlang der Erstreckung der zweiten Elektrode (134) in Bezug auf die Anordnung gemeinsam genutzt werden, und wobei die phasengesteuerte Ultraschallvorrichtung dazu konfiguriert ist, durch die gemeinsam genutzten Steuersignale an den ersten Elektroden und den zweiten Elektroden für jedes Wandlerelement eine Phasenverzögerung des Wandlerelements basierend auf einer gewünschten Phasenverzögerung für jedes der Wandlerelemente zu generieren, die dazu konfiguriert ist, eine kombinierte Ultraschallwelle zu bilden;

**dadurch gekennzeichnet, dass**:

das piezoelektrische Material zwei Polarisationszustände aufweist, wobei sich eine Phase einer emittierten Ultraschallwelle durch das Wandlerelement (110) zwischen den beiden Polarisationszustände des piezoelektrischen Materials um 180° unterscheidet; und

wobei die phasengesteuerte Ultraschallvorrichtung (100) dazu konfiguriert ist, den Polarisationszustand des piezoelektrischen Materials von ausgewählten Ultraschallwandlerelementen (110) einzeln von einem der beiden Polarisationszuständen des piezoelektrischen Materials auf den anderen der beiden Polarisationszustände des piezoelektrischen Materials zu ändern, bevor mindestens eine Teilmenge der Ultraschallwandlerelemente (110) in der Anordnung aktiviert wird, um die kombinierte Ultraschallwelle zu bilden, wobei die Ultraschallwandlerelemente (110), für welche der Polarisationszustand des piezoelektrischen Materials geändert wird, basierend auf einer Beziehung zwischen der Phasenverzögerung des zu generierenden Wandlerelements (110) und der gewünschten Phasenverzögerung des Wandlerelements (110) zum Bilden der kombinierten Ultraschallwelle ausgewählt werden.

2. Phasengesteuerte Ultraschallvorrichtung nach Anspruch 1, ferner umfassend eine Steuereinheit (140), die dazu konfiguriert ist, Informationen von einer gewünschten kombinierten Ultraschallwelle zu empfangen, die von der phasengesteuerten Ultraschallvorrichtung (100) zu bilden ist, um Phasenverzögerungen der Steuersignale zu bestimmen, die auf die ersten Elektroden (132) und die zweiten Elektroden (134) anzuwenden sind, und eine Differenz zwischen einer gewünschten Phasenverzögerung jedes Wandlerelements (110) und einer Phasenverzögerung, die durch die Steuersignale generiert wird, zu bestimmen.

3. Phasengesteuerte Ultraschallvorrichtung nach Anspruch 2, wobei die Steuereinheit (140) ferner dazu konfiguriert ist zu bestimmen, welche Wandlerelemente (110) zu aktivieren sind, um die gewünschte kombinierte Ultraschallwelle zu bilden.

4. Phasengesteuerte Ultraschallvorrichtung nach Anspruch 2 oder 3, wobei die Steuereinheit (140) ferner dazu konfiguriert ist, Phasenverzögerungen von Steuersignalen für die ersten Elektroden (132) und die zweiten Elektroden (134) für die mindestens eine Teilmenge der Ultraschallwandlerelemente (110) zu bestimmen, wobei die Phasenverzögerungen basierend auf dem Optimieren einer Phasenverzögerung einer Vielzahl von Ultraschallwandlerelementen (110), die durch die Steuersignale jeder der ersten Elektroden (132) und der zweiten Elektroden (134) für die mindestens eine Teilmenge der Ultraschallwandlerelemente (110) gesteuert werden, bestimmt werden.

5. Phasengesteuerte Ultraschallvorrichtung nach einem der Ansprüche 2 bis 4, wobei die Steuereinheit (140) dazu konfiguriert ist, basierend auf dem Bestimmen der Differenz zwischen der gewünschten Phasenverzögerung jedes Wandlerelements (110) und der Phasenverzögerung, die durch die Steuersignale generiert wird, Wandlerelemente (110) zu identifizieren, für die eine Differenz zwischen 90 bis 270° bestimmt wird, und die identifizierten Wandlerelemente (110) zum Ändern des Polarisationszustands des piezoelektrischen Materials auszuwählen.

6. Phasengesteuerte Ultraschallvorrichtung nach einem der vorhergehenden Ansprüche, wobei das piezoelektrische Material dazu konfiguriert ist, den Polarisationszustand basierend darauf zu ändern, dass eine Spannung, die eine Schwellenspannung überschreitet, zwischen der ersten Elektrode (132) und der zweiten Elektrode (134) angelegt wird, wobei ein Vorzeichen der angelegten Spannung den Polarisationszustand des piezoelektrischen Materials steuert.

7. Phasengesteuerte Ultraschallvorrichtung nach einem der vorhergehenden Ansprüche, wobei das piezoelektrische Material Polyvinylidenfluorid, PVDF, oder Polyparaxylylen ist.

8. Phasengesteuerte Ultraschallvorrichtung nach einem der vorhergehenden Ansprüche, wobei die kombinierte Ultraschallwelle einen Fokuspunkt einer konstruktiven Interferenz von Ultraschallwellen umfasst, die von jedem der Wandlerelemente (110) in der mindestens einen Teilmenge der Ultraschallwandlerelemente (110) emittiert werden.

9. Phasengesteuerte Ultraschallvorrichtung nach Anspruch 8, wobei die kombinierte Ultraschallwelle eine Vielzahl von Fokuspunkten konstruktiver Interferenz umfasst.

10. Phasengesteuerte Ultraschallvorrichtung nach einem der vorhergehenden Ansprüche, ferner umfassend eine Steuersignalgenerierungseinheit (150), die dazu konfiguriert ist, die Steuersignale zu generieren, die an die ersten Elektroden (132) und die zweiten Elektroden (134) anzulegen sind.

11. Phasengesteuerte Ultraschallvorrichtung nach einem der vorhergehenden Ansprüche, wobei jedes Wandlerelement (110) eine mechanische Membran (116) umfasst, welche die Schicht (118) von piezoelektrischem Material umfasst, wobei die Schicht (118) von piezoelektrischem Material dazu konfiguriert ist, die Emission einer Ultraschallwelle durch die mechanische Membran (116) zu induzieren.

12. System zur Benutzerinteraktion, umfassend:

ein Benutzerinteraktionssteuergerät (230) zum Bestimmen einer gewünschten haptischen Rückmeldung, die einem Benutzer bereitzustellen ist; und
die phasengesteuerte Ultraschallvorrichtung (100) nach einem der vorhergehenden Ansprüche, wobei die phasengesteuerte Ultraschallvorrichtung (100) dazu eingerichtet ist, eine Eingabe durch das Benutzerinteraktionssteuergerät (230) zu empfangen, um die kombinierte Ultraschallwelle zu definieren, die der gewünschten haptischen Rückmeldung entspricht, wobei die phasengesteuerte Ultraschallvorrichtung (100) dazu konfiguriert ist, die kombinierte Ultraschallwelle an die Umgebungsluft auszugeben, um die gewünschte haptische Rückmeldung in der Nähe der phasengesteuerten Ultraschallvorrichtung (100) bereitzustellen.

13. System nach Anspruch 12, ferner umfassend eine Anzeige (210) zur Benutzerinteraktion, wobei die phasengesteuerte Ultraschallvorrichtung (100) an oder in der Nähe der Anzeige montiert ist, um eine haptische Rückmeldung über der Anzeige (210) als Reaktion auf eine Benutzerinteraktion mit der Anzeige (210) bereitzustellen.

14. Verfahren zum Bilden einer kombinierten Ultraschallwelle basierend auf einer phasengesteuerten Ultraschallvorrichtung (100), die eine Anordnung von Ultraschallwandlerelementen (110), eine Vielzahl von ersten Elektroden (132) und eine Vielzahl von zweiten Elektroden (134) umfasst, wobei sich jede erste Elektrode (132) in einer ersten Richtung in Bezug auf die Anordnung von Ultraschallwandlerelementen (110) erstreckt und sich jede zweite Elektrode (134) in einer zweiten Richtung, die anders als die erste Richtung ist, in Bezug auf die Anordnung von Ultraschallwandlerelementen (110) erstreckt, so dass jedes Wandlerelement (110) in der Anordnung einer einzigen ersten Elektrode (132) und einer einzigen zweiten Elektrode (134) zugeordnet ist, wobei jedes Wandlerelement (110) in der Anordnung eine Schicht (118) von piezoelektrischem Material zwischen der ersten Elektrode (132) und der zweiten Elektrode (134) umfasst, die dazu konfiguriert ist, eine Vibration des piezoelektrischen Materials zu steuern, um eine Emission einer Ultraschallwelle durch das Wandlerelement zu induzieren, wenn sie basierend auf einer Differenz zwischen den Steuersignalen, die an die erste Elektrode (132) und die zweite Elektrode (134) angelegt werden, denen das Wandlerelement zugeordnet ist, aktiviert wird, wobei Steuersignale, die an eine erste Elektrode (132) angelegt werden, von den Wandlerelementen (110) entlang der Erstreckung der ersten Elektrode (132) in der ersten Richtung gemeinsam genutzt werden, und Steuersignale, die an eine zweite Elektrode (134) angelegt werden, von den Wandlerelementen (110) entlang der Erstreckung der zweiten Elektrode (134) in der zweiten Richtung gemeinsam genutzt werden, wobei sich eine Phase einer emittierten Ultraschallwelle durch das Wandlerelement (110) zwischen den beiden Polarisationszustände des piezoelektrischen Materials um 180° unterscheidet; wobei das Verfahren umfasst:

Empfangen (302) von Informationen über eine gewünschte kombinierte Ultraschallwelle, die von der phasengesteuerten Ultraschallvorrichtung (100) zu bilden ist;

Bestimmen (308) von Phasenverzögerungen der Steuersignale, die an die ersten Elektroden (132) und die zweiten Elektroden (134) anzulegen sind, um die gewünschte kombinierte Ultraschallwelle zu bilden;

Bestimmen (310) einer Differenz zwischen einer gewünschten Phasenverzögerung jedes Wandlerelements (110) und einer Phasenverzögerung, die durch die bestimmten Steuersignale generiert wird;

basierend auf dem Bestimmen der Differenz, Auswählen (312) von Wandlerelementen (110), für die ein Polarisationszustand eines piezoelektrischen Materials des Wandlerelements (110) zu ändern ist;

Ändern (314) des Polarisationszustands des piezoelektrischen Materials der ausgewählten Ultraschallwandlerelemente (110) von einem der beiden Polarisationszustände des piezoelektrischen Materials auf den anderen der beiden Polarisationszustände des piezoelektrischen Materials; und

Anlegen (316) der Steuersignale an die ersten Elektroden (132) und die zweiten Elektroden (134) unter Verwendung der bestimmten Phasenverzögerungen, um die gewünschte kombinierte Ultraschallwelle zu bilden.

15. Verfahren nach Anspruch 14, ferner umfassend das Bestimmen (304) der Wandlerelemente (110), die zu aktivieren sind, um die gewünschte kombinierte Ultraschallwelle zu bilden, und vor dem Ändern des Polarisationszustands des piezoelektrischen Materials der ausgewählten Ultraschallwandlerelemente (110), Einstellen (306) eines Polarisationszustands des piezoelektrischen Materials jedes der Wandlerelemente (110) in der mindestens einen Teilmenge auf einen ersten Polarisationszustand.

## Revendications

1. Appareil à ultrasons à commande de phase, l'appareil (100) comprenant :

un réseau d'éléments transducteurs à ultrasons (110) ;

une pluralité de premières électrodes (132) et une pluralité de deuxièmes électrodes (134), dans lequel chaque première électrode (132) s'étend dans une première direction par rapport au réseau d'éléments transducteurs à ultrasons (110) et chaque deuxième électrode (134) s'étend dans une deuxième direction, différente de la première direction par rapport au réseau d'éléments transducteurs à ultrasons (110) de telle sorte que chaque élément transducteur (110) du réseau soit associé à une première électrode (132) et une deuxième électrode (134) ;

dans lequel chaque élément transducteur (110) comprend une couche (118) de matériau piézoélectrique entre la première électrode (132) et la deuxième électrode (134) configurée pour réguler une vibration du matériau piézoélectrique afin d'induire l'émission d'une onde à ultrasons par l'élément transducteur (110) sur la base d'une différence entre les signaux de commande appliqués à la première électrode (132) et à la deuxième électrode (134) à laquelle l'élément transducteur est associé, dans lequel les signaux de commande appliqués à une première électrode (132) sont partagés par les éléments transducteurs (110) le long de l'extension de la première électrode (132) par rapport au réseau et des signaux de commande appliqués à une deuxième électrode (134) sont partagées par les éléments transducteurs (110) le long de l'extension de la deuxième électrode (134) par rapport au réseau, et l'appareil à ultrasons à commande de phase est configuré pour générer, par les signaux de commande partagés sur des premières électrodes et des deuxièmes électrodes pour chaque élément transducteur, un retard de phase de l'élément transducteur sur la base d'un retard de phase souhaité pour chacun des éléments transducteurs configurés pour former une onde à ultrasons combinée ; **caractérisé en ce que** :

le matériau piézoélectrique présente deux états de polarisation, dans lesquels une phase d'une onde à ultrasons émise par l'élément transducteur (110) diffère de 180° entre les deux états de polarisation du matériau piézoélectrique ; et

dans lequel l'appareil à ultrasons à commande de phase (100) est configuré pour modifier individuellement l'état de polarisation du matériau piézoélectrique des éléments transducteurs à ultrasons sélectionnés (110), d'un des deux états de polarisation du matériau piézoélectrique à l'autre des deux états de polarisation du matériau piézoélectrique, avant d'activer au moins un sous-ensemble des éléments transducteurs à ultrasons (110) dans le réseau pour former l'onde à ultrasons combinée, dans lequel les éléments transducteurs à ultrasons (110) pour lesquels l'état de polarisation du matériau piézoélectrique est modifié sont sélectionnés en fonction sur une relation entre le retard de phase de l'élément transducteur (110) à générer et le retard de phase souhaité de l'élément transducteur (110) pour former l'onde à ultrasons combinée.

2. Appareil à ultrasons à commande de phase selon la revendication 1, comprenant en outre une unité de commande (140), qui est configurée pour recevoir des informations d'une onde à ultrasons combinée souhaitée devant être formée par l'appareil ultrasons à commande de phase (100), pour déterminer les retards de phase des signaux de commande à appliquer aux premières électrodes (132) et aux deuxièmes électrodes (134), et pour déterminer une différence entre un retard de phase souhaité de chaque élément transducteur (110) et un retard de phase généré par les signaux de commande.

3.   Appareil à ultrasons à commande de phase selon la revendication 2, dans lequel l'unité de commande (140) est en outre configurée pour déterminer quels éléments transducteurs (110) doivent être activés pour former l'onde à ultrasons combinée souhaitée.

4.   Appareil à ultrasons à commande de phase selon la revendication 2 ou 3, dans lequel l'unité de commande (140) est en outre configurée pour déterminer des retards de phase des signaux de commande pour les premières électrodes (132) et les deuxièmes électrodes (134) pour au moins un sous-ensemble des éléments transducteurs à ultrasons (110), dans lequel les retards de phase sont déterminés sur la base d'une optimisation du retard de phase d'une pluralité d'éléments transducteurs à ultrasons (110) étant commandés par les signaux de commande de chacune des premières électrodes (132) et des deuxièmes électrodes (134) pour au moins un sous-ensemble des éléments transducteurs à ultrasons (110).

5.   Appareil à ultrasons à commande de phase selon une quelconque des revendications 2 à 4, dans lequel l'unité de commande (140) est configurée, sur la base de la détermination de la différence entre le retard de phase souhaité de chaque élément transducteur (110) et le retard de phase généré par les signaux de commande, pour identifier les éléments transducteurs (110) pour lesquels une différence entre 90-270° est déterminée et pour sélectionner les éléments transducteurs identifiés (110) pour modifier l'état de polarisation du matériau piézoélectrique.

6.   Appareil à ultrasons à commande de phase selon une quelconque des revendications précédentes, dans lequel le matériau piézoélectrique est configuré pour modifier l'état de polarisation sur la base d'une tension dépassant une tension de seuil appliquée entre la première électrode (132) et la e deuxième électrode (134), dans lequel un signe de la tension appliquée régule l'état de polarisation du matériau piézoélectrique.

7.   Appareil à ultrasons à commande de phase selon une quelconque des revendications précédentes, dans lequel le matériau piézoélectrique est du polyfluorure de vinylidène, PVDF ou du polyparaxylylène.

8.   Appareil à ultrasons à commande de phase selon une quelconque des revendications précédentes, dans lequel l'onde à ultrasons combinée comprend un point focal d'interférence constructive des ondes à ultrasons émises par chacun des éléments suivants, les éléments transducteurs (110) dans au moins un sous-ensemble des éléments transducteurs à ultrasons (110).

9.   Appareil à ultrasons à commande de phase selon la revendication 8, dans lequel l'onde à ultrasons combinée comprend une pluralité de points focaux d'interférence constructive.

10.  Appareil à ultrasons à commande de phase selon une quelconque des revendications précédentes, comprenant en outre une unité de génération de signaux de commande (150), qui est configurée pour générer les signaux de commande à appliquer aux premières électrodes (132) et aux deuxièmes électrodes (134).

11.  Appareil à ultrasons à commande de phase selon une quelconque des revendications précédentes, dans lequel chaque élément transducteur (110) comprend une membrane mécanique (116) comprenant la couche (118) de matériau piézoélectrique, la couche (118) de matériau piézoélectrique étant configurée pour induire l'émission d'une onde à ultrasons par la membrane mécanique (116).

12.  Système d'interaction d'utilisateur, comprenant :

un contrôleur d'interaction utilisateur (230) pour déterminer un retour d'information d' haptique souhaitée à fournir à un utilisateur ; et
l'appareil à ultrasons à commande de phase (100) selon une quelconque des revendications précédentes, dans lequel l'appareil à ultrasons à commande de phase (100) est agencé pour recevoir une entrée du contrôleur d'interaction d'utilisateur (230) pour définir l'onde à ultrasons combinée correspondant au retour d'information d'haptique souhaitée, dans lequel l'appareil à ultrasons à commande de phase (100) est configuré pour émettre l'onde à ultrasons combinée dans l'air ambiant afin de fournir le retour d'information d'haptique souhaité à proximité de l'appareil à ultrasons à commande de phase (100).

13. Système selon la revendication 12, comprenant en outre un écran (210) pour l'interaction d'utilisateur, dans lequel l'appareil à ultrasons à commande de phase (100) est monté sur ou à proximité de l'écran pour fournir un retour d'information d'haptique au-dessus de l'écran (210) en réponse à l'interaction d'utilisateur avec l'écran (210).

14. Procédé de formation d'une onde à ultrasons combinée basé sur un appareil à ultrasons à commande de phase (100) comprenant un réseau d'éléments transducteurs à ultrasons (110), une pluralité de premières électrodes (132) et une pluralité de deuxièmes électrodes (134), dans lequel chaque première électrode (132) s'étend dans une première direction par rapport au réseau d'éléments transducteurs à ultrasons (110) et chaque deuxième électrode (134) s'étend dans une deuxième direction, différente de la première direction, par rapport au réseau d'éléments transducteurs à ultrasons (110) de telle sorte que chaque élément transducteur (110) du réseau soit associé à une première électrode (132) et une deuxième électrode (134), dans lequel chaque élément transducteur à ultrasons (110) dans le réseau comprend une couche (118) de matériau piézoélectrique entre la première électrode (132) et la deuxième électrode (134) configurée pour réguler une vibration du matériau piézoélectrique afin d'induire l'émission d'une onde à ultrasons par l'élément transducteur lors d'une activation sur la base d'une différence entre les signaux de commande appliqués à la première électrode (132) et à la deuxième électrode (134) à laquelle l'élément transducteur est associé, dans lequel les signaux de commande appliqués à une première électrode (132) sont partagés par les éléments transducteurs (110) le long de l'extension de la première électrode (132) dans la première direction et des signaux de commande appliqués à une deuxième électrodes(134) sont partagés par les éléments transducteurs (110) le long de l'extension de la deuxième électrode (134) dans la deuxième direction, dans lequel le matériau piézoélectrique présente deux états de polarisation, dans lequel une phase d'une onde à ultrasons émise par l'élément transducteur (110) diffère de 180° entre les deux états de polarisation du matériau piézoélectrique ; ledit procédé comprenant de :

recevoir (302) des informations d'une onde à ultrasons combinée souhaitée devant être formée par l'appareil à ultrasons à commande de phase (100) ;
déterminer (308) les retards de phase des signaux de commande à appliquer aux premières électrodes (132) et aux deuxièmes électrodes (134) pour former l'onde à ultrasons combinée souhaitée ;
déterminer (310) une différence entre un retard de phase souhaité de chaque élément transducteur (110) et un retard de phase généré par les signaux de commande déterminés ;
sur la base de la détermination de la différence, sélectionner (312) des éléments transducteurs (110) pour lesquels un état de polarisation d'un matériau piézoélectrique de l'élément transducteur (110) doit être modifié ;
modifier (314) l'état de polarisation du matériau piézoélectrique des éléments transducteurs à ultrasons sélectionnés (110), d'un des deux états de polarisation du matériau piézoélectrique à l'autre des deux états de polarisation du matériau piézoélectrique ; et
appliquer (316) les signaux de commande aux premières électrodes (132) et aux deuxièmes électrodes (134) utilisant les retards de phase déterminés pour former l'onde à ultrasons combinée souhaitée.

15. Procédé selon la revendication 14, comprenant en outre la détermination (304) de quels éléments transducteurs (110) doivent être activés pour former l'onde à ultrasons combinée souhaitée et, avant de modifier l'état de polarisation du matériau piézoélectrique des éléments transducteurs à ultrasons sélectionnés (110), définir (306) un état de polarisation du matériau piézoélectrique de chacun des éléments transducteurs (110) dans au moins un sous-ensemble à un premier état de polarisation.

*Fig. 1*

*Fig. 2*

*Fig. 3a*

*Fig. 3b*

Optimal phase delays

*Fig. 4*

Difference with optimal phase delays

*Fig. 5*

Difference with optimal phase delays

*Fig. 6*

**Fig. 7**

```
┌─────────────────────────────────┐
│   Receive information of desired │──── 302
│      combined ultrasonic wave    │
└─────────────────────────────────┘
                  │
                  ▼
┌─────────────────────────────────┐
│   Determine subset of transducer │──── 304
│     elements in array to be used │
└─────────────────────────────────┘
                  │
                  ▼
┌─────────────────────────────────┐
│      Set polarization state of each │
│      transducer element to first │──── 306
│         polarization state       │
└─────────────────────────────────┘
                  │
                  ▼
┌─────────────────────────────────┐
│   Determine phase delays of control │
│     signals to be applied to first and │──── 308
│          second electrodes       │
└─────────────────────────────────┘
                  │
                  ▼
┌─────────────────────────────────┐
│   Determine difference between desired │
│      phase delay and generated phase │──── 310
│     delay for each transducer element │
└─────────────────────────────────┘
                  │
                  ▼
┌─────────────────────────────────┐
│   Select transducer elements for which │
│    a polarization state is to be changed │──── 312
└─────────────────────────────────┘
                  │
                  ▼
┌─────────────────────────────────┐
│   Change polarization state of piezoelectric │
│   material of selected transducer elements │──── 314
└─────────────────────────────────┘
                  │
                  ▼
┌─────────────────────────────────┐
│     Apply control signals to first and │──── 316
│          second electrodes       │
└─────────────────────────────────┘
```

*Fig. 8*

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20170205500 A
- US 20150260691 A
- US 4460841 A
- JP 2016002352 B

**Non-patent literature cited in the description**

- **Y. MONNAI et al.** HaptoMime: Mid-Air Haptic Interaction with a Floating Virtual Screen. *UIST '14 Proceedings of the 27th annual ACM symposium on User interface software and technology,* 05 October 2014, 663-667